Europäisches Patentamt

European Patent Office

Office européen des brevets

(11) Veröffentlichungsnummer: **0 346 903**
**A2**

## (12) EUROPÄISCHE PATENTANMELDUNG

(21) Anmeldenummer: 89110891.2

(22) Anmeldetag: 15.06.89

(51) Int. Cl.⁴: **H05K 13/02 , H05K 13/04**

(30) Priorität: 16.06.88 DE 3820540

(43) Veröffentlichungstag der Anmeldung:
**20.12.89 Patentblatt 89/51**

(84) Benannte Vertragsstaaten:
**DE FR GB**

(71) Anmelder: **Multitest Elektronische Systeme GmbH**
**Arnulfstrasse 13**
**D-8200 Rosenheim-Aisingerwies(DE)**

(72) Erfinder: **Ueberreiter, Ekkehard**
**Drosselweg 4**
**D-8201 Raubling(DE)**
Erfinder: **Willberg, Hans-Heinrich**
**Malerwinkelweg 23**
**D-8201 Altofing/ Bad Feilnbach(DE)**
Erfinder: **Ulrich, Thomas**
**Dianastrasse 12b**
**D-8209 Stephanskirchen(DE)**

(74) Vertreter: **Schmidt-Evers, Jürgen, Dipl.-Ing. et al**
**Patentanwälte Dipl.-Ing. H. Mitscherlich**
**Dipl.-Ing. K. Gunschmann Dipl.-Ing.**
**Dr.rer.nat. W. Körber Dipl.-Ing. J.**
**Schmidt-Evers Dipl.-Ing. W. Melzer**
**Steinsdorfstrasse 10**
**D-8000 München 22(DE)**

(54) **Vorrichtung zur Vereinzelung von gleichartigen Gegenständen, insbesondere elektronischen Bauelementen, wie IC's.**

(57) Eine Vorrichtung zur Vereinzelung von gleichartigen Gegenständen (3,41), insbesondere elektronischen Bauelementen, wie IC's, die in einem ein Gefälle aufweisenden Förderkanal (4) aufeinanderfolgend angeliefert werden, mit einem im Bereich des Förderkanals (4) angeordneten Stoppelement (15), welches im wesentlichen quer zur Förderrichtung (37) so verstellbar ist, daß es den in der Reihe jeweils vordersten Gegenstand zurückhält bzw. festklemmt und mit einer Steuerschaltung (P), welche die Verstellbewegung des Stoppelements (15) taktartig steuert, ist so auszugestalten, daß sie bei Gewährleistung einer verhältnismäßig langen Lebensdauer geeignet ist, für insbesondere hinsichtlich ihrer Länge unterschiedliche Bauelemente eingesetzt zu werden. Dies wird dadurch erreicht, daß im Bereich des Förderkanals (4) in Förderrichtung (37) nach dem Stoppelement (15) ein auf das Eintreffen eines freigegebenen Gegenstandes (3,41) ansprechbarer Sensor (12) angeordnet ist, der mit der Steuerschaltung (P) verbunden ist, und daß die Steuerschaltung (P) so ausgelegt ist, daß die Taktfrequenz und/oder das Verhältnis zwischen Andruck- und Abhebezeit des Stoppelements (15) in Abhängigkeit von der Eintreff-Folgefrequenz oder Entnahmefrequenz der freigegebenen Gegenstände (3,41) am Sensor (12) verändert wird.

FIG. 1

## Vorrichtung zur Vereinzelung von gleichartigen Gegenständen, insbesondere elektronischen Bauelementen, wie IC's

Die Erfindung bezieht sich auf eine Vorrichtung nach dem Oberbegriff des Anspruchs 1.

Bei der Herstellung von elektronischen Bauelementen ist es aus verschiedenen Gründen in vielen Fällen erforderlich, die Bauelemente, die zwecks rationeller Fertigung unmittelbar hintereinanderliegend einen Führungs- bzw. Förderkanal durchlaufen, zu vereinzeln. Das Erfordernis der Vereinzelung ergibt sich z.B. beim Prüfen elektronischer Bauelemente.

In der DE-OS 32 17 531 ist eine Vorrichtung zur Vereinzelung von elektronischen Bauelementen beschrieben und dargestellt, die ein in Durchlaufrichtung des vorhandenen Förderkanals für die Bauelemente umlaufendes elastisches Band gebildet ist, das einen Wandabschnitt des Förderkanals ersetzt und in Kontakt mit den vordersten Bauelementen einer im Förderkanal vorhandenen Reihe von Bauelementen steht. Durch gezieltes Antreiben und Anhalten des Förderbandes nach Maßgabe eines in Durchlaufrichtung hinter dem Förderband angeordneten Sensors, der den Fortgang des jeweils ersten, das Förderband verlassenden Bauelementes ermittelt, läßt sich eine Vereinzelung der Bauelemente erzielen, wobei die Vorrichtung unabhängig ist von der jeweiligen Länge der Bauelemente, da durch unterschiedlich große Einschaltzeiten des Förderbandes unterschied lichen Längen der Bauelemente Rechnung getragen werden kann. Bei dieser bekannten Ausgestaltung ist mit einem verhältnismäßig großen Verschleiß des elastischen Förderbandes zu rechnen, so daß ein solches verhältnismäßig oft mit einem erheblichen Arbeits- und Zeitaufwand ausgetauscht werden muß. Außerdem ist eine solche Vereinzelungsvorrichtung verhältnismäßig raumaufwendig, sie läßt sich daher bei mehreren nebeneinanderliegenden, ein Magazin bildenden Förderkanälen schlecht integrieren.

Bei einer anderen, in der DE-OS 35 31 120 beschriebenen Vorrichtung zur Vereinzelung von elektronischen Bauelementen sind zur Vereinzelung letzterer zwei quer zum Förderkanal verstellbare und mit jeweils zwei hintereinanderliegenden Bauelementen zusammenwirkende Stoppelemente vorgesehen, von denen das erste Stoppelement einen Anschlag für das jeweils erste Bauelement bildet, während das zweite Stoppelement auf das unmittelbar dahinterliegende Bauelement drückt. Die beiden Stoppelemente werden so angetrieben, daß jeweils nur ein Stoppelement in den Förderkanal eintaucht. Beim jeweiligen Eintauchen des zweiten Stoppelements wird das jeweils erste Bauelement freigegeben, so daß es unter Vereinzelung aufgrund der vorhandenen Neigung des Förderkanals weiterrutscht. Bei dieser Ausgestaltung besteht eine Abhängigkeit der Vereinzelungsvorrichtung vn der Länge der Bauelemente.

Es ist gemäß DE-OS 36 38 430 auch schon eine Vorrichtung zum Vereinzeln von elektronischen Bauelementen bekannt geworden, bei der die Vereinzelung dadurch stattfindet, daß das jeweils vorderste und vor einem Anschlag liegende Bauelement der Zuführungsreihe mit Hilfe eines Greifers quer zur Zuführungsreihe entnommen und einem vorhandenen Prüfkopf zugeführt wird. Es hat sich in der Praxis erwiesen, daß es auch bei einer solchen Entnahme der Bauelemente aus einer Zuführungsreihe vorteilhaft ist, die Bauelemente zu vereinzeln, so daß der Greifer jeweils ein vereinzeltes Bauelement ergreift. Bei unvereinzelten Bauelementen können sich beim quer zur Zuführungsreihe gerichteten Herausziehen der Bauelemente aufgrund von Gratbildungen (Spritzgrate) an den einander zugewandten Enden der Bauelemente Ablöseprobleme ergeben, die insbesondere dann zu Funktionsstörungen führen, wenn es sich um einen Sauggreifer handelt.

Der Erfindung liegt die Aufgabe zugrunde, eine Vorrichtung der eingangs bezeichneten Art so auszugestalten, daß sie bei Gewährleistung einer verhältnismäßig langen Lebensdauer geeignet ist, für insbesondere hinsichtlich ihrer Länge unterschiedliche Bauelemente eingesetzt zu werden.

Diese Aufgabe wird durch die kennzeichnenden Merkmale des Anspruchs 1 gelöst.

Bei der erfindungsgemäßen Ausgestaltung wird die durch die Wirksamkeit des Stoppelements herbeigeführte Verweilzeit des jeweils ersten Bauelements im Bereich des Stoppelments in Abhängigkeit von der sich ergebenden oder einer gewünschten Taktfrequenz an der Entnahmestelle oder einer Weiterverarbeitungsstelle verändert. Hierdurch ist die Verweilzeit und somit die Vereinzelungsgeschwindigkeit an eine konstante oder veränderliche Eintreff- oder Entnahme-Folgefrequenz anpaßbar, woraus sich die Vereinzelung nach Beendigung der Verweilzeit des jeweils ersten Bauelements im Bereich des Stoppelements ergibt. Dabei ist die Vereinzelungsvorrichtung auf unterschiedlich lange Bauelemente einstellbar. Aufgrund der Anpaßbarkeit der Vereinzelung an unterschiedliche Taktfrequenz an der Entnahmestelle der Weiterverarbeitungs stelle ist auch eine Anpaßbarkeit an unterschiedliche Arbeitsgeschwindigkeiten der der Vereinzelungsvorrichtung nachgeordneten Verarbeitungs- bzw. Prüfgerätes möglich. Die erfindungsgemäße Lösung ist funktionssicher, von einfacher und preiswert herstellbarer Bauweise sowie von langer Lebensdauer, da am Stoppelement wenn überhaupt nur ein vernachläßigbar geringer Verschleiß auftritt.

Im Rahmen der Erfindung ist es möglich, zur Veränderung der Vereinzelungsfrequenz die Frequenz der Impulse, mit denen das Stoppelement gegen das zu vereinzelnde Bauelement beaufschlagt wird, die Kontakt- bzw. Andruckzeit, während der das Stoppelement mit dem zu vereinzelnden Bauelement in Kontakt steht, und/oder die Freigabezeit, in der das Stoppelement mit dem Bauelement nicht in Kontakt steht, zu verändern.

In den Unteransprüchen sind Weiterbildungen der Erfindung vorhanden, die zu einer einfachen, preiswerten und kleinen Bauweise, sicheren Funktion, einfachen Einstellbarkeit sowie Handhabungsfreundlichkeit auch bei der Zuordnung mehrerer Förderkanäle im Sinne eines Magazins beitragen.

Nachfolgend wird die Erfindung anhand von in einer Zeichnung dargestellten bevorzugten Ausführungsbeispielen näher erläutert. Es zeigt:

Fig. 1 eine erfindungsgemäß ausgestaltete Vorrichtung zur Vereinzelung von IC's im vertikalen Längsschnitt;

Fig. 2 den Teilschnitt II-II in Fig. 1;

Fig. 3 eine abgewandelte Ausgestaltung der Vorrichtung im vertikalen Längsschnitt;

Fig. 4 den Teilschnitt IV-IV in Fig. 3.

Die allgemein mit 1 bezeichnete Vereinzelungsvorrichtung ist einem allgemein mit 2 bezeichneten Magazin für IC's 3 zugeordnet. Das Magazin 2 ist einem nicht dargestellten Gerät zum Prüfen von elektronischen Bauelementen, hier die IC's 3, zugeordnet, und es weist eine Mehrzahl parallel zueinander verlaufender Führungs- bzw. Förderkanäle 4 auf, die auf einer geneigten Magazinplatte 5 angeordnet sind. Die Neigung ist so groß, daß die IC's 3 aufgrund ihres Eigengewichts in den Förderkanälen 4 nach unten rutschen. Jedem Förderkanal 4 ist eine Vereinzelungsvorrichtung 1 zugeordnet.

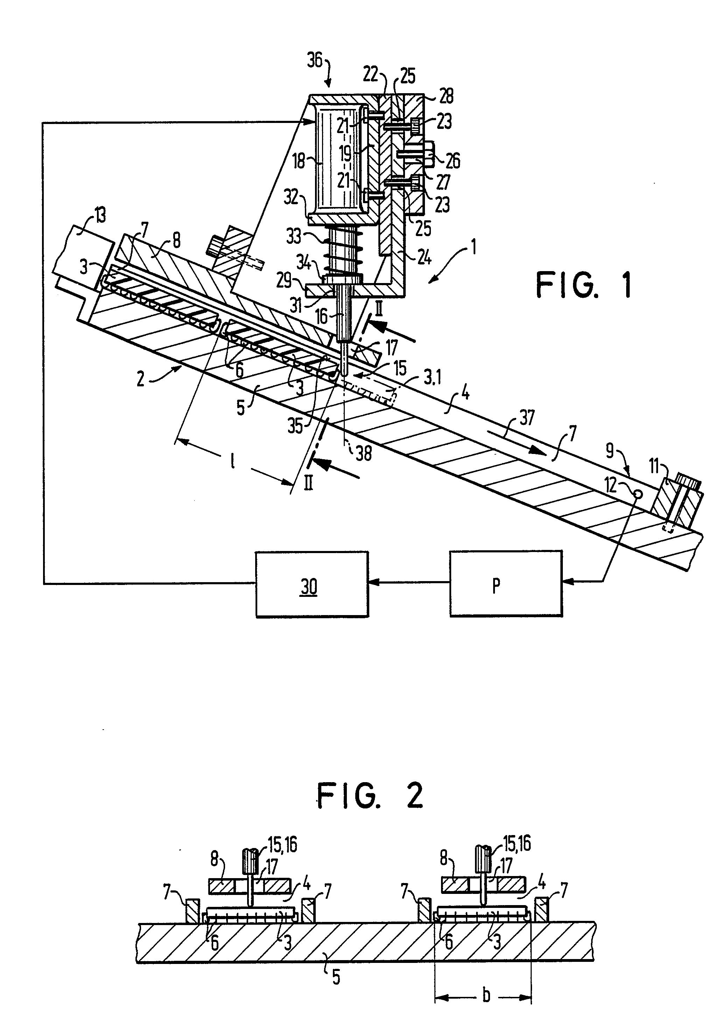

Beim Ausführungsbeispiel gemäß Fig. 1 und 2 ist das Magazin 2 bzw. sind die Förderkanäle 4 zur Aufnahme von IC's 3 eingerichtet, die Plättchenform mit einem Kunststoffgehäuse und auf dem gesamten Umfang angeordneten Kontaktelementen aufweisen. Solche IC's sind unter der Kurzbezeichnung PLCC bekannt. Die mit 6 bezeichneten Kontaktelemente überragen eine Breitseite der IC's. Beim vorliegenden Ausführungsbeispiel ist diese Breitseite nach unten gerichtet, d.h. die IC's 3 liegen bzw. rutschen auf den nach unten weisenden Kontaktelementen 6, während die obere Breitseite von Kontaktelementen 6 frei ist.

Die Förderkanäle 4 sind jeweils durch zwei seitliche und eine obere Führungsleiste 7,8 gebildet bzw. begrenzt, wodurch sich der jeweilige Förderkanal 4 ergibt, in dem die IC's mit Bewegungsspiel aufgenommen sind.

Die Förderkanäle 4 erstrecken sich von den nebeneinander angeordneten Vereinzelungsvorrichtungen 1 über eine gewisse Wegstrecke bis zu einer Entnahmestelle 9 für die IC's 3, die jeweils durch ein den Förderkanal 4 begrenzendes Anschlagstück 11 definiert ist, zu dem die vereinzelten IC's 3 rutschen. Vor dem Anschlagstück 11 ist ein Sensor 12, vorzugsweise in Form einer Lichtschranke, vorgesehen, der ein Signal abzugeben vermag, wenn ein vereinzeltes IC 3 an der Entnahmestelle 9 vorhanden ist.

Am oberen Ende der Magazinplatte 5 sind in Flucht mit den Förderkanälen 4 angeordnete, andeutungsweise dargestellte Magazinstangen 13 vorgesehen, die in im einzelnen nicht dargestellte Anschlüsse bzw. Fassungen einsetzbar und somit auswechselbar sind, um eine leere Magazinstange 13 gegen eine mit IC's 3 gefüllte Magazinstange 13 auszutauschen.

Jede Vereinzelungsvorrichtung 1 weist ein allgemein mit 15 bezeichnetes, oberhalb des zugehörigen Förderkanals 4 angeordnetes Stoppelement in Form eines sich quer zum Förderkanal 4 erstreckenden, aufwärts und abwärts verschiebbaren stiftförmigen Stößels 16, der durch eine Öffnung 17 in der oberen Führungsleiste 8 in den Querschnitt des Förderkanals 4 einzutauchen und durch Kontakt mit dem in diesem Bereich angeordneten IC 3 dieses zu stoppen vermag, so daß es nicht weiterrutscht. An seinem dem Förderkanal 4 abgewandten Ende ist der Stößel 16 als Anker einer elektriscen Spule 18 ausgebildet bzw. mit einem solchen Anker verbunden. Der Spulenkörper 18 ist innenseitig an einem Schenkel eines winkel-oder U-förmigen Halterstücks 19 befestigt, das mittels Schrauben 21 an einer Zwischenplatte 22 befestigt ist. Die Zwischenplatte 22 ist ebenfalls mittels zwei Schrauben 23 an einem Führungswinkel 24 befestigt, wobei die Schrauben 23 das Befestigungsteil des Führungswinkels 24 in Langlöchern 25 durchfassen. In gleicher Weise, d.h. mittels wenigstens einer Schraube 26 in einem Langloch 27 ist auch der Führungswinkel 24 an einer Befestigungsplatte 28 befestigt, wobei die Langlöcher 25,27 sich im wesentlichen senkrecht erstrecken. Auf diese Weise läßt sich das Stoppelement 15 quer zur Magazinplatte 5 hinsichtlich seiner Höhe (Schraube 26) und seines Hubes (Schrauben 23) ein- und feststellen. Die Befestigungsplatte 28 ist Teil eines Halters 30, der auf der Magazinplatte 5 oder den Führungsleisten 7,8 angeordnet und gehalten ist.

Der Stößel 16 durchfaßt den Führungsschenkeln 29 des Führungswinkel 24 in einem Führungsloch 31, wodurch er mit dem auch im unteren Schenkel 32 des Halters 19 angeordneten, jedoch nicht dargestellten Führungsloch eine sichere Führung erhält. Zwischen den Schenkel 29,32 ist eine Druckfeder 33 eingespannt, die am Schenkel 32 abgestützt ist und gegen einen am Führungsschenkel 29 anliegenden Ringansatz 34 des Stößels 16 wirkt. Somit ist der Stößel 16 in seine ausgeschobene Hubendstellung vorgespannt. Diese Hubendstellung ist tiefer anzuordnen, als die Oberseite 35 des zu vereinzelnden IC's 3, so daß das Stoppelement 15 mit der Vorspannung gegen das IC 3 wirkt und dieses gegen seine Unterlage drückt und daran hemmt, weiterzurutschen. Die Vorspannung ist so groß zu bemessen, daß auch beim Vorhandensein einer langen Reihe IC's 3 in der Magazinstange 13 und dem daraus resultierenden Gewicht das zu vereinzelnde IC 3 sicher gestoppt werden kann.

Bei einer neuen Beschickung des jeweiligen Förderkanals 4 mit IC's stößt das erste zu vereinzelnde IC 3 gegen das Stoppelement 15, das somit als Anschlag wirkt. Dagegen befindet sich das Stoppelement 15 nach begonnener Vereinzelung immer an der Oberseite 35 des zu vereinzelnden IC's 3, wobei letzteres eine Position einnehmen kann, die in Fig. 1 andeutungsweise dargestellt mit 3.1 bezeichnet ist. Diese Position liegt jedoch nicht fest, sie kann variieren.

Der Sensor 12 ist durch eine elektrische Steuerleitung mit einem Prozessor P verbunden, der durch eine weitere elektrische Steuerleitung über eine Strom-Steuerschaltung 30 mit dem allgemein mit 36 bezeichneten Elektromagnetantrieb des Stößels 16 verbunden ist und letzteren so steuert, daß der Stößel 16 mit einer gewissen Taktfrequenz vom zu vereinzelnden IC 3 abhebt und aufgrund der Federkraft wieder gegen das IC drückt. Durch eine Vergrößerung oder Verkleinerung der Taktfrequenz des Stößels 16, der Andruckzeit des Stößels 16 am IC 3 und/oder der Abhebezeit des Stößels 16 vom IC 3 läßt sich die Verweilzeit des zu vereinzelnden IC's 3 im Bereich des Stoppelementes 15 und somit die Schnelligkeit der Vereinzelung steuern bzw. regeln. Im vorliegenden Fall wird die Schnelligkeit der Vereinzelung nach Maßgabe der Eintreff-Folgefrequenz oder der Entnahme-Folgefrequenz an der Entnahmestelle 9 gesteuert. D.h., die Vereinzelung wird an den Durchlauf der IC's 3 nach der Vereinzelungsvorrichtung 1 angepaßt, wobei sie auch an die Schnelligkeit der Entnahme an der Entnahmestelle 9 angepaßt werden kann. Die Anordnung ist vorzugsweise so getroffen,, daß das Stoppelement 15 jedes zu vereinzelnden IC 3 wenigstens zweimal oder dreimal kontaktiert. Hierdurch wird, da eine eindeutige Position des zu vereinzelnden IC's 3 gegenüber dem Stoppelement 16 nicht vorgegeben ist, verhindert, daß beim Vorhandensein eines aus einer langen Reihe IC's 3 resultierenden, in die allgemein mit 37 bezeichnete Förderrichtung wirksamen, verhältnismäßig hohen Druckes das dem zu vereinzelnden IC 3 folgende IC 3 unbeabsichtigt durchrutscht.

Da der Stößel 16 durch die Federkraft in seine Stoppstellung beaufschlagt ist, ist auch bei Stromausfall die Stoppfunktion gewährleistet, so daß bei Stromeintritt die Vereinzelungsvorrichtung 1 störungsfrei weiterarbeiten kann.

Vorzugsweise wird die Vereinzelung durch Verlängerung oder Verkürzung entweder der Andruckzeit des Stößels 16 oder der Abhebezeit des Stößels 16 gesteuert. Im einzelnen funktioniert dies folgendermaßen. Nach Abgang eines vereinzelten IC's 3 vom Stoppelement 15 wird der Stößel 16 gegen das nachgerutschte, sich unter ihm befindliche IC 3 wenigstens zweimal im Sinne der Taktfolge beaufschlagt, wobei der Sensor 12 prüft, ob das abgegangene IC 3 angekommen ist. Dann, wenn der Sensor 12 die Entnahme des IC's 3 an der Entnahmestelle 9 signalisiert, wird das nunmehr zu vereinzelnde IC 3 freigegeben Wenn jedoch auch bei längster Andruckzeit (für längte IC's) vom Sensor 12 kein IC signalisiert wird, ermittelt der Prozessor P automatisch, daß der betreffende Förderkanal 4 leer ist oder wenigstens ein IC 3 darin verklemmt ist. Dann kann ein Signal ausgelöst werden und/oder es kann auch der oder ein nächster Förderkanal 4 in Funktion gesetzt und dessen Stoppelement 15 vom Prozeßor P gesteuert werden.

Insbesondere bei längeren Wegen zwischen der Vereinzelungsvorrichtung 1 und der Entnahmestelle 9 ist es auch möglich, daß das zu vereinzelnde IC 3 freigegeben wird, bevor der Sensor 12 die Entnahme an der Entnahmestelle 9 signalisiert. Der Prozessor P ist entsprechend programmiert.

Beim Herabrutschen der IC's 3 wird der Druck auf das erste IC 3 geringer, je kürzer die IC-Reihe vor dem Stoppelement 15 ist. Das bedeutet, daß die IC's 3 eine längere Rutschzeit erhalten. Die Taktzeit bzw. -frequenz des Stoppelements 15 wird dementsprechend verlängert (selbstregelnd). Unabhängig davon wird die kürzeste Taktfrequenz gespeichert und bei Inbetriebnahme des oder eines nächsten Förderkanals 4 als Steuerkriterium eingesetzt.

Auf diese Weise ist eine Vereinzelungsvorrichtung 1 geschaffen,, die völlig unabhängig von der Länge 1 der IC's 3 und auch deren Breite b bzw. deren Gewicht ist.

Im Rahmen der Erfindung ist es möglich, die das Stoppelement 15 aufweisende Stoppeinrichtung so anzuordnen,, daß die Längsachse 38 des Stößels 16 in oder gegen die Förderrichtung 37 geneigt ist, vgl. Fig. 1, bei der eine Neigung entgegen der Förderrichtung vorhanden ist. Bei einer solchen Ausgestaltung übt das Stoppelement 15 bei seinem Kontakt mit dem zu vereinzelnden IC 3 eine Längsbewegung auf letzteres aus, wodurch Haftreibung aufgehoben oder zumindest verringert und ein verbesserter Durchlauf erreicht wird.

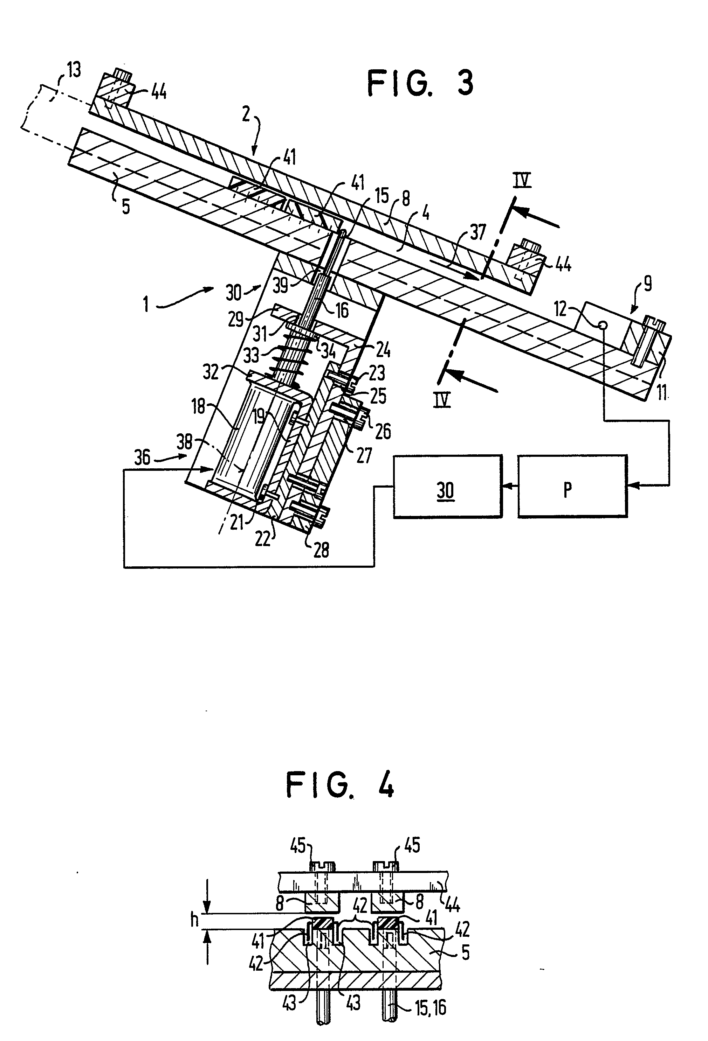

Das Ausführungsbeispiel gemäß Fig. 3 und 4 funktioniert prinzipiell entsprechend dem ersten Ausführungsbeispiel. Hier ist die Vereinzelungsvorrichtung 1 jedoch unterhalb des zugehörigen Förderkanals 4 angeordnet, d.h. der Halter 30 ist an der Unterseite der Magazinplatte 5 befestigt, wobei der Stößel 16 durch eine Öffnung 39 in der Magazinplatte 5 von unten in den Förderkanal 4 hineinbewegt wird, gegen die Unterseite der hier mit 41 bezeichneten IC's wirkt und diese während der Stoppfunktion gegen die obere Führungsleiste 8 drückt. Beim vorliegenden Ausführungsbeispiel dient diese Verein zelungsvorrichtung 1 zur Vereinzelung von sogenannten "dual in line"-IC's 41, die nur zu beiden Seiten Kontaktelemente 42 aufweisen. Beim vorliegenden Ausführungsbeispiel sind die Kontaktelemente 42 nach unten gerichtet, wobei sie in jeweils zwei Führungsnuten 43 des Förderkanals 4 eintauchen. Hierdurch ist die seitliche Führung für die IC's 41 gewährleistet, so daß auf besondere seitliche Führungsleisten 7 wie beim esten Ausführungsbeispiel verzichtet werden kann. Aus Fig. 4 ist erkennbar, daß die oberen Führungsleisten 8 unterseitig an quer zu den Förderkanälen 4 gerichtete Trägerleisten 44 mittels Schrauben 45 befestigt sind, die mehrere oder alle vorhandenen oberen Führungsleisten 8 tragen. Vorzugsweise sind die Trägerleisten 44 in nicht dargestellter Weise höhenverstellbar angeordnet, so daß die Höhe h der Förderkanäle 4 einstellbar und an die zu verarbeitenden IC's anpaßbar ist.

In vergleichbarer Weise ist es auch vorteilhaft, die obere und die seitlichen Führungsleisten 7,8 gemäß Fig. 1 vertikal bzw. seitlich verstellbar und in der jeweiligen Verstellposition feststellbar anzuordnen, so daß auch hier die Höhe h bzw. Breite b der Förderkanäle 4 an die Querschnittsabmessungen der zu verarbeitenden IC's 3 anpaßbar ist.

**Ansprüche**

1. Vorrichtung zur Vereinzelung von gleichartigen Gegenständen (3,41), insbesondere elektronischen Bauelementen, wie IC's, die in einem ein Gefälle aufweisenden Förderkanal (4) aufeinanderfolgend angeliefert werden, mit einem im Bereich des Förderkanals (4) angeordneten Stoppelement (15), welches im wesentlichen quer zur Förderrichtung (37) so verstellbar ist, daß es den in der Reihe jeweils vordersten Gegenstand zurückhält bzw. festklemmt und mit einer Steuerschaltung (P), welche die Verstellbewegung des Stoppelementes (25) taktartig steuert, dadurch gekennzeichnet, daß im Bereich des Förderkanals (4) in Förderrichtung (37) nach dem Stoppelement (15) ein auf das Eintreffen eines freigegebenen Gegenstandes (3,41) ansprechbarer Sensor (12) angeordnet ist, der mit der Steuerschaltung (P) verbunden ist, und daß die Steuerschaltung (P) so ausgelegt ist, daß die Taktfrequenz und/oder das Verhältnis zwischen Andruck- und Abhebezeit des Stoppelements (15) in Abhängigkeit von der Eintreff-Folgefrequenz oder Entnahmefrequenz der freigegebenen Gegenstände (3,41) am Sensor (12) verändert wird.

2. Vorrichtung nach Anspruch 1, dadurch gekennzeichnt, daß die Steuerschaltung (P) so ausgelegt ist, daß die Taktfrequenz und/oder die Andruckzeit des Stoppelements (15) verringert wird, wenn sich die Eintreff-Folgefrequenz oder Entnahmefrequenz verringert und umgekehrt.

3. Vorrichtung nach Anspruch 1 oder 2, dadurch gekennzeichnet, daß die Steuerschaltung (P) die Taktfrequenz für das Stoppelement (15) so regelt, daß das Stoppelement (15) jeden Gegenstand (3,41) wenigstens zweimal aber höchstens dreimal kontaktiert.

4. Vorrichtung nach einem der Ansprüche 1 bis 3, dadurch gekennzeichnt, daß das Stoppelement (15) ein quer zur Förderrichtung (37) verschiebbarer Stößel (16) ist.

5. Vorrichtung nach einem der Ansprüche 1 bis 4, dadurch gekennzeichnet, daß das Stoppelement (15) mittels eines Elektromagneten (36) verstellbar ist.

6. Vorrichtung nach einem der Ansprüche 1 bis 5, dadurch gekennzeichnet, daß das Stoppelement (15) durch Federkraft in Richtung auf den zu vereinzelnden Gegenstand (3,41) beaufschlagt ist und daß ein zur Verstellung des Stoppelements (15) dienender Verstellantrieb (36) der Federkraft entgegenwirkt.

7. Vorrichtung nach einem der Ansprüche 1 bis 6, dadurch gekennzeichnet, daß das Stoppelement (15) quer zur mit ihm zusammenwirkenden Oberseite des Gegenstandes (3,41) verstellbar und in der jeweiligen Verstellposition feststellbar ist.

8. Vorrichtung nach einem der Ansprüche 1 bis 7, dadurch gekennzeichnet, daß der Hub des Stoppelementes (15) einstellbar ist.

9. Vorrichtung nach einem der Ansprüche 1 bis 8, dadurch gekennzeichnet, daß das Stoppelement (15) oberseitig des Förderkanals (4) angeordnet ist.

10. Vorrichtung nach einem der Ansprüche 1 bis 9, dadurch gekennzeichnet, daß das Stoppelement (15) unterseitig des Förderkanals (4) angeordnet ist.

11. Vorrichtung nach einem der Ansprüche 4 bis 10, dadurch gekennzeichnet, daß die Achse (38) des Stößels (16) mit der Förderrichtung (37) einen spitzen oder stumpfen Winkel einschließt.

12. Vorrichtung nach einem der Ansprüche 4 bis 11, dadurch gekennzeichnet, daß der Stößel (16) mit der den Anschlußkontakten (6) entgegengesetzten Oberseite (35) der IC's (3) zusammenwirkt.

13. Vorrichtung nach einem der Ansprüche 4 bis 11, dadurch gekennzeichnet, daß in der unteren oder oberen Wand (5,8) des Förderkanals (4) Nuten (43) für die Kontaktelemente (42) der IC's (41) vorgesehen sind.

FIG. 1

FIG. 2

# FIG. 3

# FIG. 4